# EUROPEAN PATENT SPECIFICATION

(11) **EP 3 240 689 B1**
(45) Date of publication and mention of the grant of the patent: **24.07.2019**
(21) Application number: 15875962.1
(22) Date of filing: 16.12.2015
(51) Int. Cl.: B41K 3/12, B41M 1/26

(54) **APPARATUS AND METHOD OF MICROCONTACT PRINTING FOR IMPROVING UNIFORMITY**
VORRICHTUNG UND VERFAHREN ZUM MIKROKONTAKTDRUCKEN ZUR VERBESSERUNG DER GLEICHFÖRMIGKEIT
APPAREIL ET PROCÉDÉ D'IMPRESSION DE MICROCONTACTS POUR AMÉLIORER L'UNIFORMITÉ

(30) Priority: 31.12.2014 US 201462098484 P
(43) Date of publication of application: 08.11.2017
(73) Proprietor: 3M Innovative Properties Company, St. Paul, MN 55133-3427 (US)
(72) Inventor: RATTRAY, Tyler J., Saint Paul, Minnesota 55133-3427 (US); PEKUROVSKY, Mikhail L., Saint Paul, Minnesota 55133-3427 (US); O'HARE, Jonathan J., Saint Paul, Minnesota 55133-3427 (US); GREGER, Richard W., Saint Paul, Minnesota 55133-3427 (US); JOHNSON, Larry L., Saint Paul, Minnesota 55133-3427 (US); FREY, Matthew H., Saint Paul, Minnesota 55133-3427 (US)
(74) Representative: Herzog, Fiesser & Partner Patentanwälte PartG mbB
(86) International application number: PCT/US2015/066085
(87) International publication number: WO 2016/109204

(56) References cited:
- EP-A2- 0 193 144
- WO-A1-2007/020962
- WO-A1-2014/105633
- WO-A2-2013/003412
- US-A1- 2013 224 636
- US-A1- 2014 102 327
- US-A1- 2014 102 327

## Description

### TECHNICAL FIELD

The present disclosure relates to apparatus and methods of micro-contact printing for improving uniformity.

### BACKGROUND

Micro-contact printing can produce fine patterns on a flexible web in a roll-to-roll (R2R) process. One of the unique characteristics of the articles created by micro-contact printing are the small scale features the process is capable of generating suitable for use in the electronics industry. For example, patterns constructed of lines with line widths smaller than 10 microns having high optical transmission and relatively high electrical conductivity can be prepared over a large area. This small line width size, along with a low density of the lines, is enabled by very fine patterning of a micro-contact printing stamp to produce materials suitable for use as, for example, a touch screen.

US 2014/102327 discloses an apparatus and a method for micro-contact printing on a substrate. An apparatus for applying a pattern onto a web of indefinite length is disclosed which comprises a roll comprising a sleeve positioned over a core with the sleeve supported for rotation by a layer of air between the sleeve and core; a micro-contact printing stamp mounted onto an outer surface of the sleeve, the micro-contact printing stamp saturated with thiol; and a web path along which the web is guided such that the web contacts the micro-contact printing stamp and rotates the sleeve. An method of applying a pattern onto a web of indefinite length material is disclosed which comprises applying a micro-contact printing stamp to a roll supported for rotation by at least one air bearing, wherein the roll com arises a sleeve positioned over a core and is supported for rotation by a layer of air between the sleeve and core; contacting the roll with the web; and translating the web while in contact with the micro-contact printing stamp so as to repeatedly imprint a pattern onto the web.

### SUMMARY

There is a desire to improve uniformity in articles produced by R2R micro-contact printing. Some R2R micro-contact printing processes are related to the transfer of ink from one or more printing stamps mounted on a roll to a functional layer on a web where the roll can be driven by the web with a contacting pressure therebetween.

The present invention provides an apparatus as defined in claim 1 and a method as defined in claim 12.

Preferred embodiments of the invention are defined in the dependent claims.

In one aspect, the present disclosure describes an apparatus of applying a pattern onto a web. The apparatus includes a roll that is configured to be rotatable about an axis thereof. One or more micro-contact printing stamps are disposed on an outer surface of the roll and are arranged in a down-web direction on the circumference of the roll with a seam between each adjacent transverse edge of the one or more micro-contact printing stamps. The web is guided along a web path such that the web contacts the outer surface of the roll along a transverse contacting line and rotates the roll. When the transverse contacting line runs across the seam, the transverse contacting line also runs across at least a portion of the one or more micro-contact printing stamps such that the web always contacts the one or more micro-contact printing stamps.

In another aspect, the present disclosure describes an apparatus for applying a pattern onto a web. The apparatus includes a cylindrical core having an outer surface, a first end with a first basal edge, and an axis thereof defining an axial direction. The cylindrical core being configured to rotatable about the axis. One or more micro-contact printing stamps are disposed at the outer surface of the cylindrical core and each include transverse edges that extend along the axial direction with a seam between each adjacent transverse edge. The respective projections of the adjacent transverse edges on the first basal edge span the projection of the seam onto the first basal edge. In some embodiments, a web is guided along a web path such that the web contacts the outer surface of the cylindrical core along a transverse contacting line and rotates the cylindrical core. When the transverse contacting line runs across the seam, the transverse contacting line also runs across at least a portion of the one or more micro-contact printing stamps such that the web always contacts the one or more micro-contact printing stamps.

In yet another aspect, the present disclosure describes a method of applying a pattern onto a web. The method includes providing a roll that is configured to be rotatable about an axis thereof. One or more micro-contact printing stamps are provided on an outer surface of the roll and are arranged in a down-web direction on the circumference of the roll with a seam between each adjacent transverse edge of the one or more micro-contact printing stamps. The method further includes guiding a web along a web path such that the web contacts the outer surface of the roll along a transverse contacting line and rotates the roll. When the transverse contacting line runs across the seam, the transverse contacting line also runs across at least a portion of the one or more micro-contact printing stamps such that the web always contacts the one or more micro-contact printing stamps.

Various unexpected results and advantages are obtained in exemplary embodiments of the disclosure. One such advantage of exemplary embodiments of the present disclosure is that the web always contacts micro-contact printing stamps mounted on an outer surface of a roll, and a consistent contacting pressure can be obtained between the web and the micro-contact printing stamps to improve uniformity in printing patterns on the web.

### Listing of Exemplary Embodiments

Exemplary embodiments are listed below. It is to be understood that any of embodiments A-N, O-T, and U to Z can be combined.
Embodiment A is an apparatus comprising:
   a roll being configured to be rotatable about an axis thereof;
   one or more micro-contact printing stamps on an outer surface of the roll, the one or more micro-contact printing stamps being arranged in a down-web direction on the circumference of the roll with a seam between each adjacent transverse edge of the one or more micro-contact printing stamps; and
   a web path along which a web is guided such that the web contacts the outer surface of the roll along a transverse contacting line and rotates the roll,
   wherein when the transverse contacting line runs across the seam, the transverse contacting line also runs across at least a portion of the one or more micro-contact printing stamps such that the web always contacts the one or more micro-contact printing stamps.
Embodiment B is the apparatus of embodiment A, wherein the adjacent transverse edges of the one or more micro-contact printing stamps have curved shapes that are complementary with each other.
Embodiment C is the apparatus of embodiment B, wherein the adjacent transverse edges have a chevron shape.
Embodiment D is the apparatus of embodiment B or C, wherein the chevron shape has a depth D in the down-web direction, the seam has a width W in the down-web direction, and the ratio of D/W is no less than 1.
Embodiment E is the apparatus of embodiment A or B, wherein a first of the adjacent transverse edges includes a protrusion in the down-web direction at each end of the first transverse edge.
Embodiment F is the apparatus of embodiment A, B or E, wherein a second of the adjacent transverse edges includes a dent or chamfer at each end of the second transverse edge that is configured to receive the protrusion of the first transverse edge.
Embodiment G is the apparatus of embodiment A or B, wherein the adjacent transverse edges have a smooth-curve shape.
Embodiment H is the apparatus of any one of the preceding embodiments, wherein the transverse contacting line has first one or more sections in contact with the micro-contact printing stamps, and second one or more sections covers the seam, and the length ratio of the first sections and the second sections is no less than 5.
Embodiment I is the apparatus of any one of the preceding embodiments, wherein the roll further comprises a sleeve on the outer surface.
Embodiment J is the apparatus of embodiment I, wherein the roll further includes a core, and the sleeve is positioned over the core with the sleeve supported for rotation by a layer of air between the sleeve and core.
Embodiment K is the apparatus of embodiment I or J, wherein the sleeve is from 5 mils (0.127 mm) to 30 mils (0.762 mm) thick.
Embodiment L is the apparatus of any one of the preceding embodiments, wherein the web path comprises an entry roller and a take-off roller, and a free span of the web between the entry roller and the take-off roller contacts the micro-printing stamp.
Embodiment M is the apparatus of embodiment L, wherein the free span is in contact with the outer surface of the roll over less than 25% of the circumference thereof.
Embodiment N is the apparatus of any one of the preceding embodiments, wherein the web path comprises a positioning roller, such that the web contacts the micro-contact stamp at a nip formed between the positioning roller and the sleeve.
Embodiment O is a method comprising:
   providing a roll that is configured to be rotatable about an axis thereof;
   providing one or more micro-contact printing stamps on an outer surface of the roll, the one or more micro-contact printing stamps being arranged in a down-web direction on the circumference of the roll with a seam between each adjacent transverse edge of the one or more micro-contact printing stamps; and
   guiding a web along a web path such that the web contacts the outer surface of the roll along a transverse contacting line and rotates the roll,
   wherein when the transverse contacting line runs across the seam, the transverse contacting line also runs across at least a portion of the one or more micro-contact printing stamps such that the web always contacts the one or more micro-contact printing stamps.
Embodiment P is the method of embodiment O, wherein the adjacent transverse edges of the one or more micro-contact printing stamps have curved shapes that are complementary with each other.
Embodiment Q is the method of embodiment O or P, wherein the adjacent transverse edges have a chevron shape.
Embodiment R is the method of embodiment Q, wherein the chevron shape has a depth D in the down-web direction, the seam has a width W in the down-web direction, and the ratio of D/W is no less than 1.
Embodiment S is the method of any one of embodiments O-R, wherein the transverse contacting line has first one or more sections in contact with the micro-contact printing stamps, and second one or more sections covers the seam, and the length ratio of the first sections and the second sections is no less than 5.
Embodiment T is the method of any one of embodiments O-R, wherein the web path comprises an entry roller and a take-off roller, and a free span of the web between the entry roller and the take-off roller is in contact with the roll over less than 25% of the circumference thereof.
Embodiment U is an apparatus comprising:
   a cylindrical core having an outer surface, a first end with a first basal edge, and an axis thereof defining an axial direction, the cylindrical core being configured to rotatable about the axis; and
   one or more micro-contact printing stamps being disposed at the outer surface of the cylindrical core, the one or more micro-contact printing stamps each including transverse edges that extend along the axial direction with a seam between each adjacent transverse edges,
   wherein the respective projections of the adjacent transverse edges on the first basal edge span the projection of the seam onto the first basal edge.
Embodiment V is the apparatus of embodiment U, further comprising a web path along which a web is guided such that the web contacts the outer surface of the cylindrical core along a transverse contacting line and rotates the cylindrical core, wherein when the transverse contacting line runs across the seam, the transverse contacting line also runs across at least a portion of the one or more micro-contact printing stamps such that the web always contacts the one or more micro-contact printing stamps.
Embodiment W is the apparatus of embodiment U or V, wherein the adjacent transverse edges of the one or more micro-contact printing stamps have curved shapes that are complementary with each other.
Embodiment X is the apparatus of embodiment W, wherein the adjacent transverse edges have a chevron shape.
Embodiment Y is the apparatus of embodiment X, wherein the chevron shape has a depth D in the down-web direction, the seam has a width W in the down-web direction, and the ratio of D/W is no less than 1.
Embodiment Z is the apparatus of embodiment W, wherein the adjacent transverse edges have a smooth-curve shape, and the seam therebetween lacks an interior angle feature.

Various aspects and advantages of exemplary embodiments of the disclosure have been summarized. The above Summary is not intended to describe each illustrated embodiment or every implementation of the present certain exemplary embodiments of the present disclosure. The Drawings and the Detailed Description that follow more particularly exemplify certain preferred embodiments using the principles disclosed herein.

### BRIEF DESCRIPTION OF THE DRAWINGS

The disclosure may be more completely understood in consideration of the following detailed description of various embodiments of the disclosure in connection with the accompanying figures, in which:
Figure 1A is a perspective side view of an apparatus, according to one embodiment.
Figure 1B illustrates projections of a portion of the apparatus of Fig. 1A.
Figure 2A is a perspective side view of a comparative apparatus.
Figure 2B illustrates projections of a portion of the comparative apparatus of Fig. 2A.
Figure 3 is a schematic view of an apparatus for carrying out a micro-contact printing method, according to one embodiment.
Figure 4 is a schematic view of an alternate embodiment of an apparatus for carrying out a micro-contact printing method, according to another embodiment.
Figure 5 is a schematic view of a micro-contact printing stamp, according to one embodiment.
Figure 6 is a schematic view of the micro-contact printing stamp of Fig. 5 mounted on a roll, according to one embodiment.
Figure 7 is a schematic view of a micro-contact printing stamp, according to anther embodiment.
Figure 8 is a schematic view of a micro-contact printing stamp, according to anther embodiment.
Figure 9 is a schematic view of a micro-contact printing stamp, according to anther embodiment.
Figure 10 is a schematic view of a micro-contact printing stamp, according to anther embodiment.
Figure 11 is a schematic view of one or more micro-contact printing stamps mounted on a roll, according to another embodiment.
Figure 12 is a schematic view of one or more micro-contact printing stamps mounted on a roll, according to another embodiment.
Figure 13 is a schematic view of one or more micro-contact printing stamps mounted on a roll, according to another embodiment.

In the drawings, like reference numerals indicate like elements. While the above-identified drawing, which may not be drawn to scale, sets forth various embodiments of the present disclosure, other embodiments are also contemplated, as noted in the Detailed Description. In all cases, this disclosure describes the presently disclosed disclosure by way of representation of exemplary embodiments and not by express limitations. It should be understood that numerous other modifications and embodiments can be devised by those skilled in the art, which fall within the scope and spirit of this disclosure.

### DETAILED DESCRIPTION

There is a desire to improve uniformity in articles produced by micro-contact printing. Some R2R micro-contact printing processes are related to the transfer of ink from one or more printing stamps mounted on a roll to a functional layer on a continuous web where the roll can be driven to rotate about an axis thereof by contacting the web. In the present disclosure, a web is guided along a web path such that the web always contacts one or more of the micro-contact printing stamps along a transverse contacting line and rotates a roll onto which the micro-contact printing stamps are mounted. The one or more micro-contact printing stamps are configured and arranged on the outer surface of the roll such that when the transverse contacting line runs across a seam, the transverse contacting line also runs across at least a portion of the micro-contact printing stamps. In this manner, a consistent contact pressure between the one or more micro-contact printing stamps and the web can be provided and uniform printing patterns can be produced on the web.

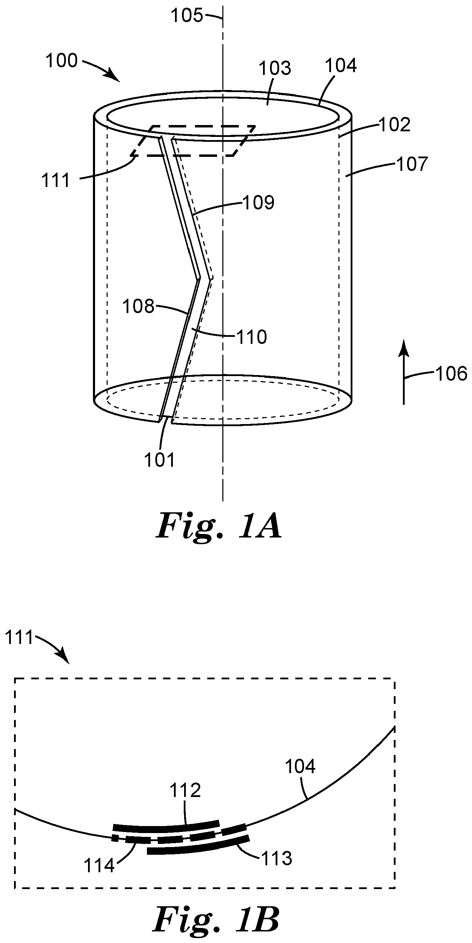

Referring to Figures 1A and 1B, the present disclosure describes an apparatus 100 for applying a pattern onto a web. The apparatus 100 shown in Fig. 1A is a roll that includes a cylindrical core 101 having an outer surface 102, a first end 103 with a first basal edge 104, and an axis 105 defining an axial direction 106. The cylindrical core 101 can be hollow or solid, and is configured to be rotatable about the axis 105. One or more micro-contact printing stamps 107 are disposed at the outer surface 102. The one or more micro-contact printing stamps 107 each include transverse edges that extend along the axial direction 106. A space between a first transverse edge 108 and a second, adjacent transverse edge 109 of the micro-contact printing stamps 107 defines a seam 110. In the embodiment of Fig. 1A, the first and second transverse edges 108 and 109 have complementary chevron or "V" shapes. Figure 1B illustrates respective projections of the first and second transverse edges 108 and 109, and the seam 110 on a projection plane 111 of Fig. 1A. The projection plane 111 is parallel to the end 103. The first transverse edge 108 has a first projection 112 onto the first basal edge 104 of the end 103. The second transverse edge 109 has a second projection 113 onto the first basal edge 104 of the end 103. The seam 110 has a projection 114 onto the first basal edge 104. The projections 112 and 113 are on the first basal edge 104, but each are shown with a displacement with respect to the first basal edge 104 for the purpose of clarity. The first projection 112 of the first transverse edge 108 and the second projection 113 of the second transverse edge 109 span the projection 114 of the seam 110. That is, the first projection 112 extends from one end of the projection 114, the second projection 113 extends from the other end of the projection 114, and the union of the projections 112 and 113 overlaps with the entirety of the projection 114.

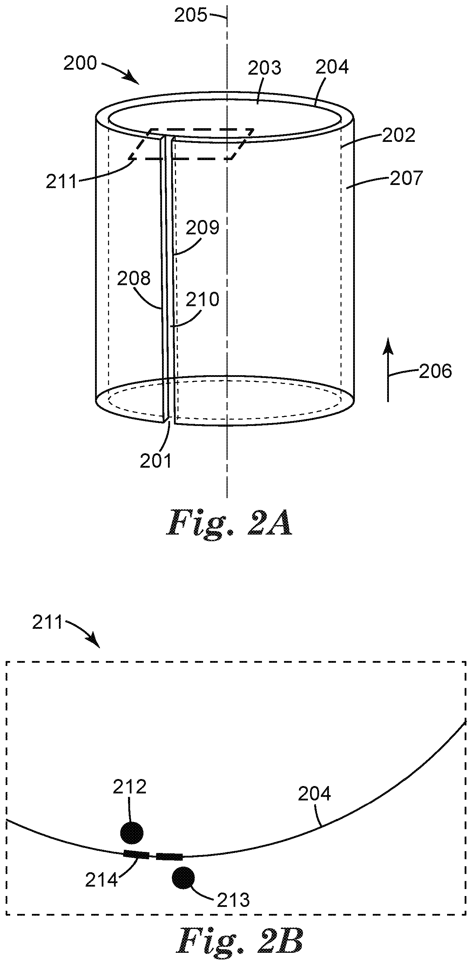

Referring to Figures 2A and 2B, a comparative apparatus 200 is now described. In contrast to the apparatus 100 depicted in Figures 1A and 1B, the comparative apparatus 200 includes a cylindrical core 201 having an outer surface 202, a first end 203 with a first basal edge 204, and an axis 205 defining an axial direction 206. The cylindrical core 210 is configured to be rotatable about the axis 205. One or more micro-contact printing stamps 207 are disposed at the outer surface 202. The one or more micro-contact printing stamps 207 each include transverse edges that extend along the axial direction 206. A space between a first transverse edge 208 and a second, adjacent transverse edge 209 of the micro-contact printing stamps 207 defines a seam 210. Figure 2B illustrates respective projections of the first and second transverse edges 208 and 209, and the seam 210 on a projection plane 211 of Fig. 2A. The first transverse edge 208 has a first projection 212 onto the first basal edge 204. The first transverse edge 208 is a straight line in the axial direction 206 and the first projection 212 is a point. The second transverse edge 209 has a second projection 213 onto the first basal edge 204. The second transverse edge 209 is a straight line in the axial direction 206 and the second projection 213 is a point. The seam 210 has a projection 214 onto the first basal edge 104. The projection 214 corresponds to the width of the seam 210. The first projection 212 of the first transverse edge 208 and the second projection 213 of the second transverse edge 209 do not span the projection 214 of the seam 210. That is, the projections 212 and 213 merely overlap with the ends or a portion instead of the entirety of the projection 214.

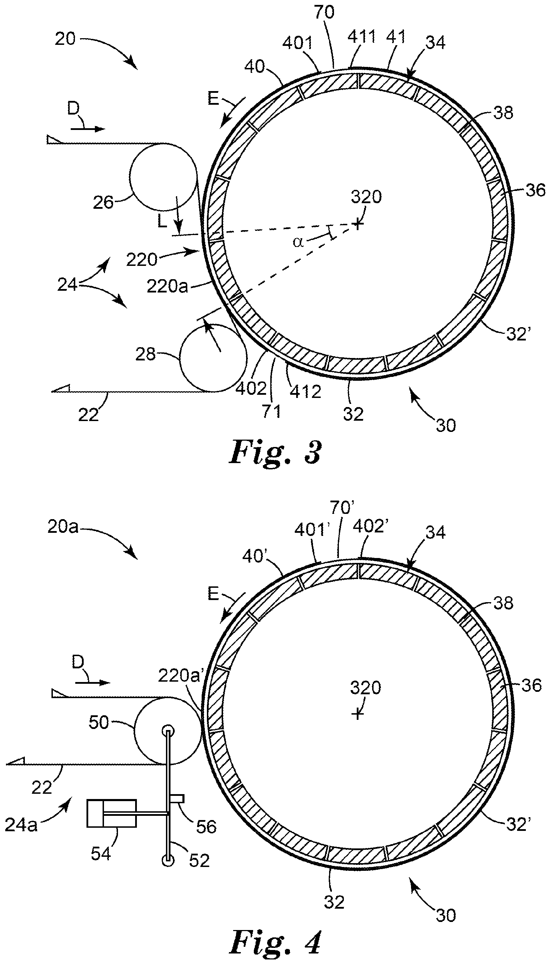

Referring to Figure 3, a schematic view of an apparatus 20 according to one embodiment is illustrated. A web 22 of indefinite length is conveyed in a direction D along a web path 24, which in the depicted embodiment includes an entry roller 26 and an exit roller 28 positioned such that the web 22 touches or wraps at least a portion of a stamp roll assembly 30. In many convenient embodiments, the entry roller 26 and the exit roller 28 are idle rollers. In other embodiments, one or the other or both of the rollers 26 and 28 can be a driven roller. The web 22 can include any of a variety of materials. In some embodiments, the web 22 may be a polymeric material such as polyethylene terephthalate (PET), polyethylene naphthalate (PEN), polycarbonate, and polyimide. The web 22 might conveniently be coated with a thin metal layer such as, for example, silver, gold, copper, nickel, etc.

The web path 24 conveys a free span of the web 22 between the entry roller 26 and the exit roller 28 into touching contact with the stamp roll assembly 30. The stamp roll assembly 30 includes a roll 32 with a cylindrical shape. In the embodiment of Fig. 3, the roll 32 includes a sleeve 32' mounted on an air bearing 34. The air bearing 34 includes a non-rotating steel core 36 having apertures 38 for the egress of an airflow that rotationally supports roll 32. Heaters or coolers may be placed in or adjacent to the core 36 or the air supply to add or remove heat from the roll 32 if desired to control the temperature of micro-contact printing stamp(s) mounted thereon.

While Fig. 3 illustrates an air bearing to mount the sleeve 32', it is to be understood that the sleeve 32' can be mounted on various bearings including, for example, plain bearings, roll bearings, ball bearings, air bearings, etc. In some embodiment, the roll 32 and the air bearing 34 can be replaced by an conventional dead shaft or live shaft roll supported for rotation by air bearings located on opposing ends of the roll. Such a system would not have a compliant layer of air between the sleeve and the core. A carbon fiber roll could be used to minimize the rotational moment of inertia present.

One or more micro-contact printing stamps can be mounted on the sleeve 32'. In the embodiment of Fig. 3, micro-contact printing stamps 40 and 41 are mounted on the sleeve 32' around its circumference. The micro-contact printing stamps 40 and 41 are arranged in a down-web direction E on the circumference of the sleeve 32' to have respective edges 401 and 411, and edges 402 and 412 adjacent to each other. Seams or gaps 70 and 71 are formed between adjacent edges 401 and 411, and adjacent edges 402 and 412, respectively. The free span of the web 22 contacts one, the other, or both of the micro-contact printing stamps 40 and 41. When the web 22 is conveyed in the direction D, the sleeve 32' is rotated in a rotation direction (i.e., the down-web direction E) around an axis 320 thereof. The contacting area between the free span of the web 22 and the sleeve 32' is an arc surface which is referred to as a contacting band 220. The contacting band 220 has a central line thereof extending in a direction generally parallel to the axis 320. The central line is referred to as a transverse contacting line 220a herein. As shown in Fig. 3, the contacting band 220 has a length L in the down-web direction E. In some embodiments, the length L of the contacting band 220 may be less than 50%, less than 25%, or even less than 15%, or further even less than 5% of the circumference of the sleeve 32'. The length L can be, for example, 2 - 4 inches (5.1 - 10.2 cm) of surface arc such as 3 inches (7.6 cm). The wrap angle α as well as the corresponding length L can be determined based on parameters such as web speed, web tension, radius of the roll, etc. Relatively smaller wrap angles can improve print quality, but may not have sufficient contact to drive the sleeve 32'.

In operation, when the sleeve 32' is rotated by the web 22 in the down-web direction E and the transverse contacting line 220a runs across the seam 70 or 71, the contacting band 220 may cover a non-uniform surface of the sleeve 32' that includes the seam 70 or 71. The non-uniform contacting surface may result in non-uniform patterns printed on the web 22. Conventional micro-contact printing stamps have a rectangular shape. When one or more of such rectangular stamps are mounted onto the sleeve 32' such as shown in Figs. 2A and 2B, a seam between adjacent stamp edges extends straightly in a direction generally parallel to the axis 320 of the sleeve 32', which may cause the sleeve 32' to deform to be an oblong shape. In addition, when the web 22 touches the surface of the sleeve 32' around the seam, an undesired step change effect due to an abrupt change of contact pressure can be generated, which may cause non-uniformness in printing patterns on the web, for example, resulting in bands of non-uniform line widths in a printed mess pattern on the web. Such non-uniformness in printing patterns are referred to as cross-web "chatter" herein.

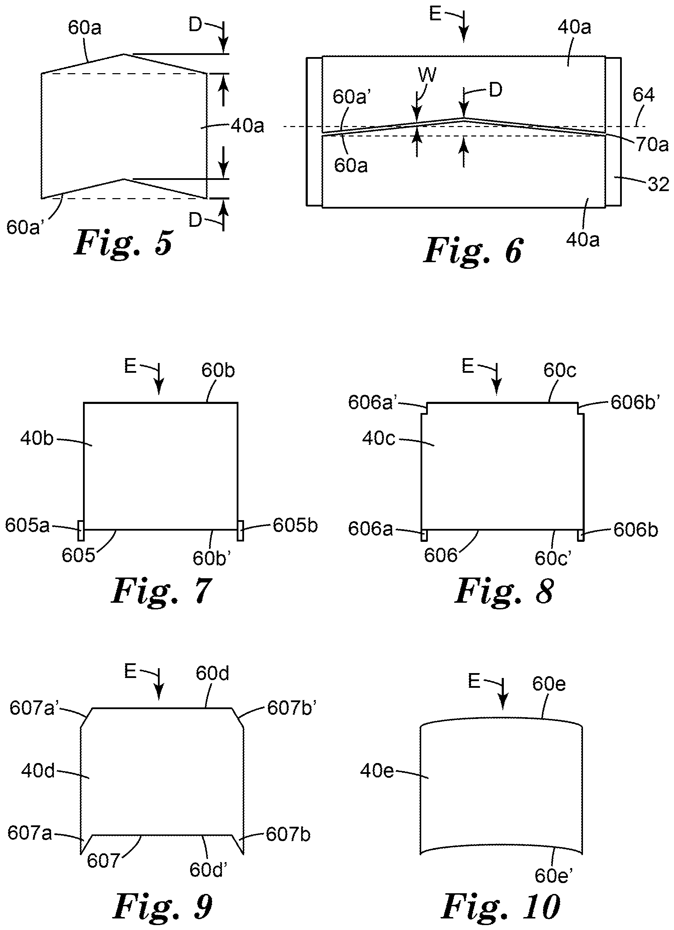

The embodiments described herein allow the web 22 to always contact one, the other, or both of the micro-contact printing stamps 40 and 41 to mitigate or prevent the cross-web "chatter". In some embodiments, when the transverse contacting line 220a runs across the seam 70 or 71, the transverse contacting line 220a also runs across at least a portion of the micro-contact printing stamps 40 and 41, which will be discussed further below in Figs. 5-10.

In some embodiments, the web 22 can make a touching contact with one or both of the micro-contact printing stamps 40 and 41 with a relatively low contact pressure, for example, less than 2 psi (13.7 kPa), or even less than 1 psi (6.9 kPa), or further even less than 0.5 psi (3.4 kPa). The web 22 may be in contact with the micro-contact printing stamp for a short time, for example, several milliseconds. Longer contact times may increase the printed width of the pattern on the substrate undesirably.

While Fig. 3 illustrates two micro-contact printing stamps 40 and 41 and two seams 70 and 71 between the respective adjacent stamp edges, it is to be understood that other numbers of stamps (i.e., one, three or more) can be mounted on a sleeve, and other numbers of seams or gaps can be formed between respective adjacent stamp edges. For example, Fig. 4, to be discussed further below, includes one stamp 40' which covers almost the entire circumference of the sleeve 32' and has two edges 401' and 402' adjacent to each other and a seam or gap 70' between the adjacent edges 401' and 402'.

The sleeves described herein such as the sleeve 32' of Figs. 3 and 4 can be built out of metals, combination of layers of metals, from composite materials that include PAN carbon fibers, pitch carbon fibers, para-aramid fibers, Kevlar fibers, and glass fibers, or from combination of layers of metals and polymeric materials, for example elastomers like rubbers. These fiber-based materials can be impregnated with polymeric materials that could include epoxies, polyesters, and vinylesters. Examples of metals suitable for building sleeves include nickel, copper, nickel/cobalt, titanium, and aluminum. A thin shell of carbon composite is also believed to be suitable for use as a sleeve. In some convenient embodiments, the sleeve 32' is composed primarily of nickel. The nickel sleeve can have a thickness of, for example, no less than 3 mils (0.076 mm), no less than 4 mils (0.102 mm), or no less than 5 mils (0.127 mm). The thickness can be, for example, no greater than 30 mils (0.762 mm), no greater than 15 mils (0.381 mm), or even no greater than 6 mils (0.152 mm). In some embodiments, the sleeve 32' has a rotational moment of inertia of, for example, less than 150, 100, 50, or 30 lb-in² (4300, 2875, 1438, or 860 N-cm²) in various embodiments. As an example, a nickel sleeve with a length of 15 inches (38.1 cm) and thickness of 10 mils and an outer diameter of 8.7 inches (22.1 cm) has a rotational moment of inertia of about 25 lb-in² (718 N-cm²). A relatively low rotational moment of inertia for the sleeve 32' can be advantageous in the disclosed micro-contact printing when the sleeve 32' is driven by the web 22.

The micro-contact printing stamps described herein can be made from polydimethylsiloxane (PDMS) such as one described in PCT Publication No. WO 2013003412 (O'Hare et al.). Other suitable micro-contact printing stamps can be made from diverse polymeric materials. Suitable polymeric materials include silicone polymers, epoxy polymers, acrylate polymers, saturated and unsaturated rubbers. Unsaturated rubbers can include: natural polyisoprene, synthetic polyisoprene, polybutadiene, chloroprene rubber, butyl rubber, halogenated butyl rubbers, styrene-butadiene rubber, nitrile rubber, and hydrogenated Nitrile Rubbers. Saturated rubbers can include ethylene propylene rubber, ethylene propylene diene rubber, epichlorohydrin rubber, polyacrylic rubber, silicone rubber, fluorosilicone rubber, fluoroelastomers, perfluoroelastomers, polyether block amides, chlorosulfonated polyethylene, and ethylene-vinyl acetate.

Micro-contact printing stamps can be made by a number of methods that include, for example, casting against masters, selective curing by actinic radiation or heat, surface machining, or laser ablation. The micro-contact printing stamp can be made from one material, have multiple layers of different materials, or can have a composite structure. Micro-contact printing stamps can be pre-made and then mounted on a rotatable surface with help of adhesive tapes, magnetic fields, or vacuum. Alternatively, micro-contact printing stamp material can be initially deposited on a rotatable surface, with a curing step following, and with a pattern making step finishing the stamp.

The micro-contact printing stamp can include multiple layers of metals, woven and non-woven fibrous materials, rigid polymers, like PET, and foams. Foams are also referred to as expanded or sponge plastics and have at least two phases, a polymer matrix and gaseous phase. Polymeric matrix can have fillers of either inorganic nature, such as glass, ceramic or metal, or of polymeric nature. Foam cell geometry can be open or closed. Suitable foams can have a range of densities from 0.1 lb/ft³ to 70 lb/ft³. Using a layer of foam between the micro-contact printing stamp and the mounting roll can provide additional compliance improving the print quality.

The diameter of the sleeve 32' or the roller 32 can vary and is often sized to be a convenient repeat of the micro-contact printing pattern. Smaller diameters may be preferred due to lower inertia and reduced air entrainment, but often pattern geometry and the ultimate size of the printing pattern dictate the diameter of the sleeve 32' or roller 32.

The tension of the web 22 can vary. Higher tensions can be used to generate more driving force for the sleeve or roll and reduce air entrainment, but also can lead to a collapse of the printing features on the micro-contact printing stamp. In some embodiments, suitable tensions can be in the range of 1-2 pound/linear inch (1.75 to 3.5 Newton/linear cm) depending on the wrap angle of the substrate on the roll 32 or sleeve 32'.

In some convenient embodiments, one or more of the entry roller 26, the exit roller 28, or the stamp roll assembly 30 may be on adjustable mounts so as to readily adjust the contacting pressure, the wrapping angle, and/or the contacting band 220 between the web 22 and the one or more micro-contact printing stamps mounted on the sleeve 32'.

Referring to Figure 4, a schematic view of an alternate embodiment of an apparatus 20a is illustrated. In this embodiment, an alternate web path 24a is employed to convey the web 22 in the direction D into touching contact with stamp roll assembly 30 along a transverse contacting line 220a'. The web 22 is maneuvered into touching contact at a nip between nip roller 50 and the stamp roll assembly 30. In the depicted embodiment, the nip roller 50 is mounted on a pivot arm 52. The contact force is controlled by a force controller, embodied as a pneumatic cylinder 54 connected to the pivot arm 52. A position stop 56 is sometimes desirable for providing an absolute limit on the movement of the positioning roller 50 towards the roll 32.

The embodiments described herein are conveniently used for printing onto an indefinite length web of polymeric material such as polyolefin, polyester phthalate, and polyimide films. Metallic surfaces can also be used as printing substrates. The metallic surface can include, for example, elemental metal, metal alloys, intermetallic compounds, metal oxides, metal sulfides, metal carbides, metal nitrides, and combinations thereof. Exemplary metallic surfaces for supporting self-assembled monolayers include gold, silver, palladium, platinum, rhodium, copper, nickel, iron, indium, tin, tantalum, as well as mixtures, alloys, and compounds of these elements.

In the embodiments of Figs. 3 and 4, the sleeve 32' or the roll 32 is driven by the web 22 to rotate about its axis 320. Changes in the contacting pressure between the web 22 and the sleeve 32' may cause undesired frictional forces at the contacting area that lead to printing defects, for example, the above mentioned cross-web "chatter". The embodiments described herein allow the web 22 to always contact the one or more micro-contact printing stamps mounted on the sleeve 32' so as to mitigate or prevent the cross-web "chatter".

As shown in Fig. 5, a micro-contact printing stamp 40a has a chevron shape where two opposite edges 60a and 60a' having complementary "V" shapes. Figure 4 illustrates the arrangement of one or more micro-contact printing stamps 40a on the roll 32. The one or more micro-contact printing stamps 40a are arranged in the down-web direction E with a seam or gap 70a between the adjacent edges 60a and 60a'. The "V" shapes of the edges 60a and 60a' each have a depth D measured in the down-web direction E. The seam 70 has a width W measured in the down-web direction E. The ratio of D/W can be, for example, no less than 1, no less than 2, no less than 3, no less than 4, or no less than 5. While not wishing to be bound by theory, it is believed that the higher the ratio of D/W, the more consistent contacting pressure between the web 22 and the stamps 40a can be achieved so as to more effectively mitigate or prevent the cross-web "chatter" issues.

The web 22 of Fig. 3 can contact the micro-contact printing stamps 40a along a transverse contacting line 64 which can be generally perpendicular to the down-web direction E. When the transverse contacting line 64 runs across the seam 70a, the transverse contacting line 64 also runs across at least a portion of the micro-contact printing stamps 40a. The one or more portions of the transverse contacting line 64 that cover the seam 70a have a total length of LI, and the one or more portions of the transverse contacting line 64 that cover the micro-contact printing stamps 40a have a total length of L2. In the embodiment of Fig. 4, the ratio of L2/L1 is about 9:1. In some embodiments, the length ratio of L2/L1 can be, for example, no less than 2:1, no less than 5:1, or no less than 10:1. While not wishing to be bound by theory, it is believed that the higher the length ratio of L2/L1, the more consistent contacting pressure can be achieved such that the cross-web "chatter" issues can be more effectively reduced.

Figure 7 illustrates a micro-contact printing stamp 40b, according to another embodiment. The micro-contact printing stamp 40b includes opposite edges 60b and 60b'. The edge 60b' includes protrusions 605a and 605b at the ends thereof to define a recess 605. The protrusions 605a and 605b each extend in the down-web direction E. The defined recess 605 at the edge 60b' has a complementary shape to an adjacent edge such as the edge 60b so as to receive the edge 60b, and a seam (not shown) can be formed between the adjacent edges 60b and 60b'.

Figure 8 illustrates a micro-contact printing stamp 40c, according to another embodiment. The micro-contact printing stamp 40c includes opposite edges 60c and 60c'. The edge 60c' includes protrusions 606a and 606b at the ends thereof. The protrusions 605a and 605b each extend in the down-web direction E. The edge 60c includes dents 606a' and 606b' at the ends thereof each having a complementary shape to the respective protrusions 606a and 606b. The edge 60c' defines a recess 606 to receive an adjacent edge such as the edge 60c, and a seam (not shown) can be formed between the adjacent edges 60c and 60c'.

Figure 9 illustrates a micro-contact printing stamp 40d, according to another embodiment. The micro-contact printing stamp 40d includes opposite edges 60d and 60d'. The edge 60d' includes protrusions 607a and 607b at the ends thereof. The protrusions 607a and 607b each extend in the down-web direction E. The edge 60d includes chamfered ends 607a' and 607b' each having a complementary shape to the respective protrusions 607a and 607b. The edge 60d' defines a recess 607 to receive an adjacent edge such as the edge 60d, and a seam (not shown) can be formed between the adjacent edges 60d and 60d'.

Figure 10 illustrates a micro-contact printing stamp 40e, according to one embodiment. The micro-contact printing stamp 40e includes opposite edges 60e and 60e' having complementary shapes of single smooth curve. The edge 60e has a convex shape and the edge 60' has a concave shape. When one or more micro-contact printing stamps 40e are mounted on the roll in the down-web direction, a seam (not shown) can be formed between the adjacent edges 60e and 60e'.

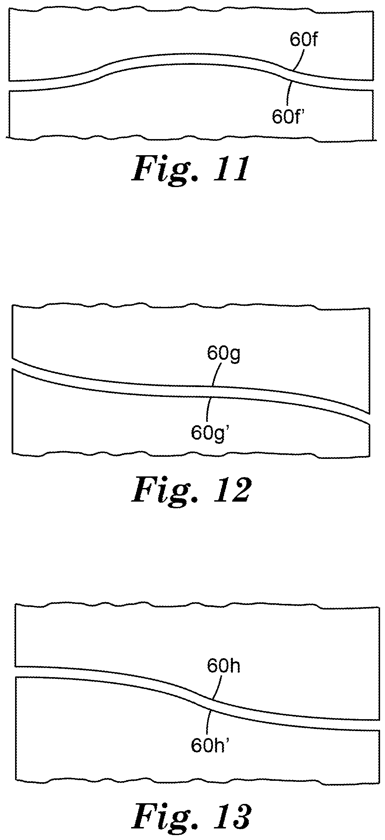

In some embodiments, the one or more micro-contact printing stamps each can include transverse edges that are smooth curves such that a seam between each adjacent transverse edge lacks an interior angle feature. The term "interior angle feature" refers to an angle feature somewhere along the adjacent transverse edges, other than at the termination of the transverse edge. Figures 11-13 illustrate embodiments where each adjacent transverse edges 60f and 60f', 60g and 60g', and 60h and 60h' lack any such interior angle features.

In addition to the micro-contact printing stamps illustrated in Figs. 5-13, micro-contact printing stamps described herein can have opposite edges with various shapes including, for example, single curve, chevron shape, dovetail shape, tongue shape, groove shape, combinations thereof. In the present disclosure, the arrangement of one or more of the micro-contact printing stamps allows a web to always contact the stamps. In this manner, a consistent contact pressure between the one or more micro-contact printing stamps and the web can be provided and uniform printing patterns can be produced on the web.

Reference throughout this specification to "one embodiment," "certain embodiments," "one or more embodiments" or "an embodiment," whether or not including the term "exemplary" preceding the term "embodiment," means that a particular feature, structure, material, or characteristic described in connection with the embodiment is included in at least one embodiment of the certain exemplary embodiments of the present disclosure. Thus, the appearances of the phrases such as "in one or more embodiments," "in certain embodiments," "in one embodiment" or "in an embodiment" in various places throughout this specification are not necessarily referring to the same embodiment of the certain exemplary embodiments of the present disclosure. Furthermore, the particular features, structures, materials, or characteristics may be combined in any suitable manner in one or more embodiments.

### Examples

### Example 1

In Example 1, a chevron shaped micro-contact printing stamp was mounted on a sleeve or a roll with a seam between adjacent edges as shown in Fig. 6. The chevron shaped micro-contact printing stamp has a depth D in a down-web direction of 0.2 inch (0.51 cm). The seam has a seam width in a direction perpendicular to the edges of about 0.25 inch (0.64 cm).

### Example 2

Example 2 is the same as Example 1 except for the micro-contact printing stamp of Example 2 having a depth D in a down-web direction of 0.35 inch (0.89 cm).

### Example 3

Example 3 is the same as Examples 1 and 2 except for the micro-contact printing stamp of Example 3 having a depth D in a down-web direction of 0.75 inch (1.91 cm).

### Example 4

Example 4 is the same as Examples 1-3 except for the micro-contact printing stamp of Example 4 having a shape as shown in Fig. 8.

### Example 5

Example 5 is the same as Examples 1-4 except for the micro-contact printing stamp of Example 5 having a shape as shown in Fig. 9.

### Comparative Example A

In Comparative Example A, a rectangular shaped micro-contact printing stamp was mounted on a sleeve or a roll with a seam between adjacent straight stamp edges. The seam extend in a direction generally parallel to the rotation axis of the sleeve and has a seam width of about 0.25 inch (0.64 cm).

The above examples are used to apply a pattern onto a web via the apparatus of Fig. 3 for carrying out a micro-contact printing method. Examples 1-5 show various improvement in "chatter" reduction compared to Comparative Example A. For Examples 1-3, the larger the depth D of the chevron shaped stamp, the more improvement in "chatter" reduction.

While the specification has described in detail certain exemplary embodiments, it will be appreciated that those skilled in the art, upon attaining an understanding of the foregoing, may readily conceive of alterations to, variations of, and equivalents to these embodiments. Accordingly, it should be understood that this disclosure is not to be unduly limited to the illustrative embodiments set forth hereinabove. In particular, as used herein, the recitation of numerical ranges by endpoints is intended to include all numbers subsumed within that range (e.g., 1 to 5 includes 1, 1.5, 2, 2.75, 3, 3.80, 4, and 5). In addition, all numbers used herein are assumed to be modified by the term "about."

Furthermore, all publications and patents referenced herein are incorporated by reference in their entirety to the same extent as if each individual publication or patent was specifically and individually indicated to be incorporated by reference. Various exemplary embodiments have been described. These and other embodiments are within the scope of the following claims.

## Claims

1. An apparatus comprising:
a roll being configured to be rotatable about an axis thereof;
one or more micro-contact printing stamps on an outer surface of the roll, the one or more micro-contact printing stamps being arranged in a down-web direction on the circumference of the roll with a seam between each adjacent transverse edge of the one or more micro-contact printing stamps; and
a web path along which a web is guided such that the web contacts the outer surface of the roll along a transverse contacting line and rotates the roll,
wherein when the transverse contacting line runs across the seam, the transverse contacting line also runs across at least a portion of the one or more micro-contact printing stamps such that the web always contacts the one or more micro-contact printing stamps.

2. The apparatus of claim 1, wherein the adjacent transverse edges of the one or more micro-contact printing stamps have curved shapes that are complementary with each other.

3. The apparatus of claim 2, wherein the adjacent transverse edges have a chevron shape.

4. The apparatus of claim 3, wherein the chevron shape has a depth D in the down-web direction, the seam has a width W in the down-web direction, and the ratio of D/W is no less than 1.

5. The apparatus of claim 1, wherein the transverse contacting line has one or more first sections in contact with the micro-contact printing stamps, and one or more second sections covers the seam, and the length ratio of the first sections and the second sections is no less than 5.

6. The apparatus of claim 1, wherein the roll further comprises a sleeve on the outer surface.

7. The apparatus of claim 6, wherein the roll further comprises a core, and the sleeve is positioned over the core with the sleeve supported for rotation by a layer of air between the sleeve and the core.

8. The apparatus of claim 6, wherein the sleeve is from 0.127 mm (5 mils) to 0.762 mm (30 mils) thick.

9. The apparatus of claim 1, wherein the web path comprises an entry roller and a take-off roller, and a free span of the web between the entry roller and the take-off roller contacts the micro-printing stamp.

10. The apparatus of claim 9, wherein the free span is in contact with the outer surface of the roll over less than 25% of the circumference thereof.

11. The apparatus of claim 1, wherein the web path comprises a positioning roller, such that the web contacts the micro-contact stamp at a nip formed between the positioning roller and the roll.

12. A method comprising:
providing a roll that is rotatable about an axis thereof;
providing one or more micro-contact printing stamps on an outer surface of the roll, the one or more micro-contact printing stamps being arranged in a down-web direction on the circumference of the roll with a seam between each adjacent transverse edge of the one or more micro-contact printing stamps; and
guiding a web along a web path such that the web contacts the outer surface of the roll along a transverse contacting line and rotates the roll,
wherein when the transverse contacting line runs across the seam, the transverse contacting line also runs across at least a portion of the one or more micro-contact printing stamps such that the web always contacts the one or more micro-contact printing stamps.

13. The method of claim 12, wherein the adjacent transverse edges of the one or more micro-contact printing stamps have curved shapes that are complementary with each other.

14. The method of claim 13, wherein the adjacent transverse edges have a chevron shape.

15. The method of claim 14, wherein the chevron shape has a depth D in the down-web direction, the seam has a width W in the down-web direction, and the ratio of D/W is no less than 1.

## Patentansprüche

1. Eine Vorrichtung, umfassend:
eine Walze, die so konfiguriert ist, dass sie um eine eigene Achse drehbar ist;
einen oder mehrere Mikrokontakt-Druckstempel auf einer Außenoberfläche der Walze, wobei der eine oder die mehreren Mikrokontakt-Druckstempel in einer Abwärts-Bahnrichtung auf dem Umfang der Walze angeordnet sind, mit einer Naht zwischen jeweils benachbarten Querkanten des einen oder der mehreren Mikrokontakt-Druckstempel; und
einen Bahnweg, entlang dem eine Bahn geführt ist, so dass die Bahn Kontakt mit der Außenoberfläche der Walze entlang einer querverlaufenden Kontaktlinie hat und dabei die Walze dreht,
wobei, wenn die querverlaufende Kontaktlinie über die Naht verläuft, die querverlaufende Kontaktlinie auch über mindestens einen Abschnitt des einen oder der mehreren Mikrokontakt-Druckstempel verläuft, so dass die Bahn immer Kontakt mit dem einen oder den mehreren Mikrokontakt-Druckstempeln hat.

2. Die Vorrichtung nach Anspruch 1, wobei die benachbarten Querkanten des einen oder der mehreren Mikrokontakt-Druckstempel gekrümmte Konturen aufweisen, die zueinander komplementär sind.

3. Die Vorrichtung nach Anspruch 2, wobei die benachbarten Querkanten eine Zickzack-Form haben.

4. Die Vorrichtung nach Anspruch 3, wobei die Zickzack-Form eine Tiefe D in der Abwärts-Bahnrichtung aufweist, die Naht eine Breite W in der Abwärts-Bahnrichtung hat und das Verhältnis von D zu W nicht kleiner als 1 ist.

5. Die Vorrichtung nach Anspruch 1, wobei die querverlaufende Kontaktlinie einen oder mehrere erste Abschnitte aufweist, die in Kontakt mit den Mikrokontakt-Druckstempeln sind, und ein oder mehrere zweite Abschnitte die Naht bedecken, und das Längenverhältnis von den ersten Abschnitten und den zweiten Abschnitten nicht weniger als 5 ist.

6. Die Vorrichtung nach Anspruch 1, wobei die Walze ferner eine Hülse auf der Außenoberfläche aufweist.

7. Die Vorrichtung nach Anspruch 6, wobei die Walze ferner einen Kern umfasst und die Hülse über dem Kern positioniert ist, wobei die Drehung der Hülse durch eine Luftschicht zwischen der Hülse und dem Kern unterstützt wird.

8. Die Vorrichtung nach Anspruch 6, wobei die Hülse eine Dicke von 0,127 mm (5 mils) bis 0,762 mm (30 mils) aufweist.

9. Die Vorrichtung nach Anspruch 1, wobei der Bahnweg eine Eingangswalze und eine Abzugswalze umfasst und eine freie Spannweite der Bahn zwischen der Eingangswalze und der Abzugswalze den Mikrodruckstempel kontaktiert.

10. Die Vorrichtung nach Anspruch 9, wobei die freie Spannweite mit der Außenoberfläche der Walze über weniger als 25 % ihres Umfangs in Kontakt steht.

11. Die Vorrichtung nach Anspruch 1, wobei der Bahnweg eine Positionierwalze umfasst, so dass die Bahn in Kontakt mit dem Mikrokontaktstempel, bei einem Spalt zwischen der Positionierwalze und der Walze, tritt.

12. Ein Verfahren, umfassend:
Bereitstellen einer Walze, die um eine eigene Achse drehbar ist;
Bereitstellen eines oder mehrerer Mikrokontakt-Druckstempel auf einer Außenoberfläche der Walze, wobei der eine oder die mehreren Mikrokontakt-Druckstempel in einer Abwärts-Bahnrichtung auf dem Umfang der Walze angeordnet sind, mit einer Naht zwischen jeweils benachbarten Querkanten des einen oder der mehreren Mikrokontakt-Druckstempel; und
Führen einer Bahn entlang eines Bahnwegs, so dass die Bahn Kontakt mit der Außenoberfläche der Walze entlang einer querverlaufenden Kontaktlinie hat und dabei die Walze dreht,
wobei, wenn die querverlaufende Kontaktlinie über die Naht verläuft, die querverlaufende Kontaktlinie auch über mindestens einen Abschnitt des einen oder der mehreren Mikrokontakt-Druckstempel verläuft, so dass die Bahn immer Kontakt mit dem einen oder den mehreren Mikrokontakt-Druckstempeln hat.

13. Das Verfahren nach Anspruch 12, wobei die benachbarten Querkanten des einen oder der mehreren Mikrokontakt-Druckstempel gekrümmte Konturen aufweisen, die zueinander komplementär sind.

14. Das Verfahren nach Anspruch 13, wobei die benachbarten Querkanten eine Zickzack-Form haben.

15. Das Verfahren nach Anspruch 14, wobei die Zickzack-Form eine Tiefe D in der Abwärts-Bahnrichtung aufweist, die Naht eine Breite W in der Abwärts-Bahnrichtung hat und das Verhältnis von D zu W nicht kleiner als 1 ist.

## Revendications

1. Appareil comprenant :
un rouleau étant configuré pour pouvoir tourner autour d'un axe de celui-ci ;
un ou plusieurs tampons d'impression à microcontact sur une surface externe du rouleau, les un ou plusieurs tampons d'impression à microcontact étant agencés dans une direction de bande vers le bas sur la circonférence du rouleau avec une couture entre chaque bord transversal adjacent des un ou plusieurs tampons d'impression à microcontact ; et
un chemin de bande le long duquel une bande est guidée de telle sorte que la bande entre en contact avec la surface externe du rouleau le long d'une ligne de contact transversale et fasse tourner le rouleau,
dans lequel, lorsque la ligne de contact transversale passe à travers la couture, la ligne de contact transversale s'étend également à travers au moins une partie des un ou plusieurs tampons d'impression à microcontact de telle sorte que la bande soit toujours en contact avec les un ou plusieurs tampons d'impression à microcontact.

2. Appareil selon la revendication 1, dans lequel les bords transversaux adjacents des un ou plusieurs tampons d'impression à microcontact ont des formes incurvées qui sont complémentaires les unes avec les autres.

3. Appareil selon la revendication 2, dans lequel les bords transversaux adjacents ont une forme en chevron.

4. Appareil selon la revendication 3, dans lequel la forme en chevron a une profondeur D dans la direction de bande vers le bas, la couture a une largeur W dans la direction de bande vers le bas, et le rapport de D/W n'est pas inférieur à 1.

5. Appareil selon la revendication 1, dans lequel la ligne de contact transversale a une ou plusieurs premières sections en contact avec les tampons d'impression à microcontact, et une ou plusieurs deuxièmes sections recouvrent la couture, et le rapport de longueur des premières sections et des deuxièmes sections n'est pas inférieur à 5.

6. Appareil selon la revendication 1, dans lequel le rouleau comprend en outre un manchon sur la surface externe.

7. Appareil selon la revendication 6, dans lequel le rouleau comprend en outre un noyau, et le manchon est positionné au-dessus du noyau avec le manchon supporté pour pouvoir tourner par une couche d'air entre le manchon et le noyau.

8. Appareil selon la revendication 6, dans lequel le manchon a une épaisseur de 0,127 mm (5 mil) à 0,762 mm (30 mil).

9. Appareil selon la revendication 1, dans lequel le chemin de bande comprend un rouleau d'entrée et un rouleau de sortie, et une portée libre de la bande entre le rouleau d'entrée et le rouleau de sortie entre en contact avec le tampon d'impression à microcontact.

10. Appareil selon la revendication 9, dans lequel la portée libre est en contact avec la surface externe du rouleau sur moins de 25 % de la circonférence de celui-ci.

11. Appareil selon la revendication 1, dans lequel le chemin de bande comprend un rouleau de positionnement, de telle sorte que la bande soit en contact avec le tampon à microcontact au niveau d'un espacement formé entre le rouleau de positionnement et le rouleau.

12. Procédé comprenant :
la fourniture d'un rouleau qui peut tourner autour d'un axe de celui-ci ;
la fourniture d'un ou plusieurs tampons d'impression à microcontact sur une surface externe du rouleau, les un ou plusieurs tampons d'impression à microcontact étant agencés dans une direction de bande vers le bas sur la circonférence du rouleau avec une couture entre chaque bord transversal adjacent des un ou plusieurs tampons d'impression à microcontact ; et
le guidage d'une bande le long d'un chemin de bande de telle sorte que la bande entre en contact avec la surface externe du rouleau le long d'une ligne de contact transversale et fasse tourner le rouleau,
dans lequel, lorsque la ligne de contact transversale passe à travers la couture, la ligne de contact transversale s'étend également à travers au moins une partie des un ou plusieurs tampons d'impression à microcontact de telle sorte que la bande soit toujours en contact avec les un ou plusieurs tampons d'impression à microcontact.

13. Procédé selon la revendication 12, dans lequel les bords transversaux adjacents des un ou plusieurs tampons d'impression à microcontact ont des formes incurvées qui sont complémentaires les unes avec les autres.

14. Procédé selon la revendication 13, dans lequel les bords transversaux adjacents ont une forme en chevron.

15. Procédé selon la revendication 14, dans lequel la forme en chevron a une profondeur D dans la direction de bande vers le bas, la couture a une largeur W dans la direction de bande vers le bas, et le rapport de D/W n'est pas inférieur à 1.
